(19) Europäisches Patentamt

European Patent Office

Office européen des brevets

(11) **EP 1 734 570 A1**

(12) **EUROPEAN PATENT APPLICATION**
published in accordance with Art. 158(3) EPC

(43) Date of publication:
20.12.2006 Bulletin 2006/51

(51) Int Cl.:
*H01L 21/60* *(2006.01)*

(21) Application number: 04716328.2

(22) Date of filing: 02.03.2004

(86) International application number:
PCT/JP2004/002534

(87) International publication number:
WO 2005/086221 (15.09.2005 Gazette 2005/37)

(84) Designated Contracting States:
DE FR GB

(71) Applicant: FUJI ELECTRIC HOLDINGS CO., LTD.
Kawasaki-shi,
Kanagawa 210-0856 (JP)

(72) Inventors:
• FUJIMOTO, Kozo
Kobe-shi,
Hyogo 657-0051 (JP)
• IKEMI, Kazutaka,
Fuji Electric Holdings Co., Ltd.
Kawasaki-shi,
Kanagawa 210-0856 (JP)
• WATANABE, Hirohiko,
Fuji Elec. Adv. Tech. Co. Ltd.
Yokosuka-shi,
Kanagawa 240-0194 (JP)

• SHIMODA, Masayoshi,
Fuji Elec. Adv. Tech. Co. Ltd.
Yokosuka-shi,
Kanagawa 240-0194 (JP)
• TANIGUTHI, Katsumi,
Fuji Elec. Adv. Tech. Co. Ltd.
Yokosuka-shi,
Kanagawa 240-0194 (JP)
• GOTO, Tomoaki,
Fuji Elec. Adv. Tech. Co. Ltd.
Yokosuka-shi,
Kanagawa 240-0194 (JP)
• MATSUMURA, Keiichi,
Fuji Elec. Creat. Supp. Serv.
Kitaadachi-gun,
Saitama 3690122 (JP)

(74) Representative: Hoffmann, Eckart
Bahnhofstrasse 103
D-82166 Gräfelfing (DE)

(54) **METHOD FOR PACKAGING ELECTRONIC COMPONENT**

(57) The present invention provides an electronic part mounting method which enables joining of electrodes at a low temperature and within a short time, can obtain the high reliability and, further, enables joining at a fine pitch. In an electronic part mounting method which joins circuit electrodes which are formed over a circuit board and die electrodes which are formed over the electronic parts thus mounting the electronic parts on the circuit board, a low-melting-point metal layer is preliminarily formed over the circuit electrode and/or the die electrode and, thereafter, the circuit electrode and the die electrode are arranged to face each other and are heated and pressurized for melting low-melting-point metal thus diffusing the low-melting-point metal into the circuit electrode and the die electrode by solid-liquid diffusion.

Fig. 1

(a)  (b)  (c)  (c)

EP 1 734 570 A1

**Description**

Technical Field

The present invention relates to a method which, in a circuit board or a module (multiple chip module) or the like which requires miniaturization, directly mounts electronic parts such as semiconductor chips on the circuit board such as a printed circuit board.

Background Art

Along with the miniaturization or the sophistication of functions of electronic equipments in recent years, a mounting method which directly mounts electronic parts such as semiconductor chips directly on a circuit board, so-called bare chip mounting, has been popularly put into practice.

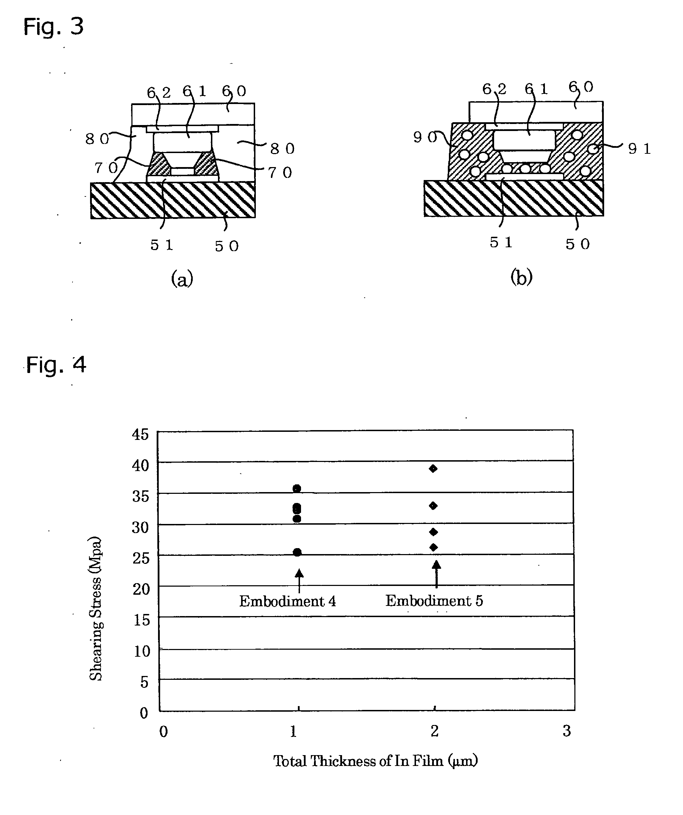

In Fig. 3(a), (b), one example of the bare chip mounting which has been performed conventionally is shown.

In Fig. 3(a), a circuit board electrode 51 which is formed on a substrate 50 and a bump (electrode) 61 made of Au or solder which is formed on a semiconductor chip 60 by way of an electrode pad 62 are brought into contact with each other in an opposed manner and, thereafter, the circuit board electrode 51 and the bump 61 are connected with each other using solder 70 and, a periphery of the solder 70 is covered with resin 80 for insulation.

Further, in Fig. 3(b), a circuit board electrode 51 which is mounted on a substrate 50 in the same manner and a bump 61 which is mounted on a semiconductor chip 60 by way of an electrode pad 62 and is made of Au or solder are arranged to face each other, and both parts are covered with an anisotropic conductive adhesive agent (ACF) 90 which is a resin containing conductive particles 91 thus joining the circuit substrate electrode 51 and the bump 61, wherein both of the circuit board electrode 51 and the bump 61 become conductive to each other by means of the conductive particles 91.

The above-mentioned method which directly connects the circuit substrate electrode and the electronic part such as the semiconductor chip and the bump is referred to as a flip-chip technique and can miniaturize the construction compared to a wire bonding method which joins a circuit board electrode and an electronic part using wires and hence, the method has been popularly used for many years as an electronic part mounting method.

Further, as the bumps which are used in the above-mentioned flip-chip technique, the formation of solder bumps made of an alloy by a vapor deposition method has been known. For example, as a method for forming lead-free solder bumps due to the formation of a multilayered film, JP-A-2002-43348 discloses a technique in which an Sn film and an M film whose film thicknesses are set to obtain the composition of $Sn_{1-X}M_X$ (M: containing at least one of Au, In and x being set to satisfy the relationship of 0<x<0.5) are alternately vapor-deposited to form a multilayered film and, thereafter, a mask is removed to form a solder bump precursor which is formed of the above-mentioned multilayered film, subsequently, annealing is applied to the solder bump precursor to make the composition of the solder bump precursor uniform and, further, the solder bump precursor is subject to the reflow at an eutectic temperature of the precursor thus forming the solder bumps.

Further, JP-A-5-9713 discloses an alloy vapor deposition method in which a base alloy whose composition and quantity are adjusted to obtain an alloy film of a desired composition and a desired thickness is preliminarily prepared in a crucible for vapor deposition, and the base alloy is completely evaporated to form a targeted alloy film on a substrate and, at the same time, the base alloy composition for vapor-depositing an alloy having the targeted composition is preliminarily obtained thus obtaining a vapor deposited film of alloy having the arbitrary composition.

As described above, in the conventional flip-chip mounting technique, the bumps 61 on the semiconductor chip 60 and the electrodes 51 on the circuit board are jointed to each other by way of solder, a resin adhesive agent or the like.

In this case, a heating temperature at the time of joining, when the joining is performed by soldering, depends on a melting point of a solder material and hence, a high temperature of 200 to 300°C is required in usual soldering thus giving rise to a drawback that an electronic part is thermally damaged. Further, when the resin adhesive agent is used, although a heating temperature is at a low temperature of 150 to 200°C, there arises a drawback that the curing of resin requires a long time of 30 to 60 minutes.

Further, the reliability of the joining portion which is represented by the strength, a fatigue lifetime of the joining portion depends on the property of a joining material which is interposed between the bumps 61 and the electrodes 51. However, when the above-mentioned solder or resin adhesive agent is used as the joining material, these materials have drawbacks with respect to the high-temperature property and the thermal fatigue lifetime thus giving rise to a drawback that the joining portion cannot obtain a sufficient reliability.

Further, in performing the solder joining, it is necessary to supply a large quantity of solder with a usual thickness of 15 μm or more and hence, it is necessary to ensure a joining distance of 300 μm or more thus making the finer joining difficult. Further, also in performing the joining using the resin adhesive agent, to satisfy the insulating property and the connection resistance, it is usually necessary to ensure a joining distance of 100 μm or more thus making the fine joining with the joining distance of less than 100 μm difficult.

Further, in the method for forming the lead-free solder bumps disclosed in JP-A-2002-43348, the joining at a low temperature for a short time is insufficient. For example, the joining at a low temperature of 200°C or less and for a short time is difficult.

Further, in the alloy vapor deposition method of the JP-A-5-9713, it is necessary to obtain the relationship between the composition of the base alloy in the crucible and the alloy composition in the vapor-deposited film and, it is necessary to determine the composition of the base alloy based on a correction curve thus giving rise to a drawback that the preparation steps up to the vapor deposition becomes cumbersome.

The present invention has been made in view of these drawbacks and it is an object of the present invention to provide a mounting method of electronic parts which directly mounts electronic parts on a substrate by arranging electrodes of electronic parts such as semiconductor chips and electrodes of a circuit board to face each other in an opposed manner, wherein the mounting method enables the joining at a low pressure and for a short period and, at the same time, can obtain a highly reliable joining portion, and enables the joining at a fine pitch.

Disclosure of the Invention

To achieve the above-mentioned object, the present invention is directed to a method which joins circuit electrodes which are made of metal and are formed on a circuit board and die electrodes which are made of metal and are formed on the electronic parts thus mounting the electronic parts on the circuit board, wherein a low-melting-point metal layer is preliminarily formed on the circuit electrode and/or the die electrode and, thereafter, the circuit electrode and the die electrode are arranged to face each other, the circuit electrode and/or the die electrode are heated at a temperature which melts at least the low-melting-point metal thus diffusing the low-melting-point metal layer into the circuit electrode and the die electrode by solid-liquid diffusion whereby the circuit electrode and the die electrode are joined to each other.

According to the method of the present invention, since the low-melting-point metal layer is formed on the electrode, although it may depend on the material of the low-melting-point metal layer, it is possible to realize the joining at a low temperature of 200°C or less, for example, and within a short time. Further, it is enough to supply an amount of low-melting-point metal layer which is sufficient for diffusion and hence, it is possible to form a thin film having a total thickness of 10 μm or less. Accordingly, a fine pattern made of plating or vapor deposition can be easily formed and hence, the circuit electrode and the die electrode can be joined with a fine interval thus realizing the more compact mounting. Further, by adopting the joining method attributed to the solid-liquid diffusion of the low-temperature melting metal layer, it is possible to eliminate a joining material such as solder, a resin adhesive agent which has drawbacks with respect to the high-temperature property and the thermal fatigue lifetime property and hence, the reliability of the joining portion is enhanced.

In the present invention, it is preferable that the above-mentioned low-melting-point metal layer contains at least one metal selected from a group consisting of SnIn, In, Bi, SnBi. Here, any one of the above-mentioned metals has a low melting point of 180°C or less and hence, these metals can be particularly preferably used in the present invention.

Further, in the present invention, it is preferable that the heating temperature at the time of the above-mentioned joining is a temperature which is 0 to 100°C higher than the melting point of the above-mentioned low-melting-point metal. Any one of the above-mentioned low-melting-point metals has a melting point of 180°C or less and hence, the heating temperature can be also set to a low temperature whereby it is possible to prevent damages attributed to heat applied to the mounting electronic parts.

Further, in the present invention, it is preferable that the total thickness of the low-melting-point metal layer which is formed preliminarily between the circuit electrode and the die electrode to be joined assumes a value which falls within a range from 0.1 to 1 μm. Here, by forming the low-melting-point metal layer into a thin film having the total thickness of 0.1 to 1 μm such that the supply quantity of the low-melting-metal becomes a quantity necessary for a diffusion reaction at the time of joining and hence, it is possible to form a fine pattern by plating or vapor deposition whereby the joining at a fine interval can be realized thus enabling the further compact mounting.

Further, by setting the total thickness of the low-melting-point metal layer to a value within the range from 0.1 to 1 μm, the low-melting-point metal is completely diffused in a base metal which constitutes the electrode and hence, the low-melting-point metal single layer disappears whereby there is no possibility that the low-melting-metal in a single body state which does not contribute to the joining is discharged from an end of the joining portion. Accordingly, the neighboring electrodes can be arranged closer to each other by narrowing a distance therebetween and hence, the present invention can cope with the mounting of electronic parts at a narrower pitch interval.

Accordingly, the mounting method of electronic parts according to the present invention is extremely suitable with respect to a point that the neighboring electrodes can be arranged closer to each other by narrowing the distance therebetween when the electronic parts to be mounted are configured such that a plurality of die elements are arranged on the same surface of a part body such as a semiconductor chip for flip chip joining particularly or when the electronic parts to be mounted is configured such that a plurality of die electrodes are arranged on at least one side of a part body such as a mini-mold-packaged IC part for surface mounting, for example.

Further, in the present invention, it is preferable that material of the above-mentioned circuit electrodes and the die electrodes is one selected from a group consisting of Cu, Ni, Au, Al or an alloy thereof. Here, with respect to one selected from the group consisting of Cu, Ni, Au, Al or an alloy thereof, a low-melting-point metal is liable to easily generate the solid-liquid diffusion and hence, the present invention is particularly preferably used.

Further, in the present invention, it is preferable that the surfaces of the above-mentioned circuit electrode and the above-mentioned die electrode are coarse surfaces having a surface roughness Ra of 0.4 to 10 $\mu$m, and the above-mentioned coarse surfaces are plastically deformed at the time of joining to enable the joining of the circuit electrode and the die electrode. Due to such a constitution, the electrode surfaces are pressurized until the electrode surfaces are plastically deformed and hence, even when the electrodes which are formed by electrolytic plating or the like, for example have irregularities on surfaces thereof attributed to precipitation, it is possible to obtain a favorable joining state.

Further, in the present invention, it is preferable that in the above-mentioned heating and pressurizing, the low-melting-point metal layer is maintained under the heating and pressurizing for a predetermined time until the low-melting-metal is completely diffused in the above-mentioned circuit electrode and the die electrode by solid-liquid diffusion. Due to such a constitution, the low-melting-point metal is completely diffused by solid-liquid diffusion thus forming one alloy layer as a whole. That is, different from soldering, the alloy layer includes no intermediate layer at the joining portion. Accordingly, the reliability of the joining portion does not depend on the characteristic of the interposed joining material but mainly depends on the base metal of the electrode and hence, the reliability of the joining portion further enhanced.

Further, in the present invention, it is preferable that the above-mentioned low-melting-point metal layer is maintained under the above-mentioned heating and pressurizing for a predetermined time until an intermediate alloy layer is formed between the above-mentioned circuit electrode and the above-mentioned die electrode. Due to such a constitution, the low-melting-point metal is not completely diffused and it is sufficient to perform heating until the intermediate alloy layer is formed whereby it is possible to largely shorten the time necessary for joining. Further, a supply quantity of the low-melting-point metal is enough so long as a quantity of low-melting-metal which is necessary for forming the intermediate alloy layer is supplied and hence, a strict management of the supply quantity of the low-melting-metal becomes no more necessary.

Further, in the present invention, it is preferable that the above-mentioned low-melting-point metal layer is formed such that at least two kinds of metal which can form an alloy are stacked in two or more layers, and the stacked metal layers are preheated to make the metal layers react with each other to form an alloy layer. Due to such a constitution, irregularities of the alloy composition or the supply quantity in the alloy layer can be eliminated and hence, it is possible to realize a stable diffusion joining at a low temperature thus acquiring the high reliable joining portion.

Further, in the present invention, it is preferable that the above-mentioned low-melting-point metal layer is formed by vapor-depositing an alloy which constitutes an evaporation source and, at the time of performing the above-mentioned vapor deposition, an evaporation pressure ratio in reaction steps of respective components of the above-mentioned alloy is controlled thus forming a film having the target alloy composition. Due to such a constitution, it is possible to perform the control of the composition of the alloy at the time of vapor deposition and hence, it is possible to turn the alloy composition of the low-melting-point metal layer into the eutectic composition which enables the joining at the lowermost temperature thus ensuring a stable diffusion joining at a low temperature.

Further, with the use of the vapor deposition method, it is possible to easily form the film having a thickness which allows the easy diffusion of the low-melting-point metal layer by the vapor deposition method.

Further, in the present invention, it is preferable that the above-mentioned low-melting-point metal layer is formed by vapor-depositing an alloy which constitutes an evaporation source and, at the time of performing the above-mentioned vapor deposition, a product of an evaporation pressure ratio and an active coefficient ratio in reaction steps of respective components of the above-mentioned alloy is controlled thus forming a film having the target alloy composition. Due to such a constitution, it is possible to perform the control of the composition of the alloy at the time of vapor deposition and hence, it is possible to turn the alloy composition of the low-melting-point metal layer into the eutectic composition which enables the joining at the lowermost temperature thus ensuring a stable diffusion joining at a low temperature. Further, with the use of the vapor deposition method, it is possible to easily form the film having a thickness which allows the easy diffusion of the low-melting-point metal layer by the vapor deposition method.

Brief Explanation of Drawings

Fig. 1   is a step view showing a principle of joining electrodes to each other in one embodiment of a mounting method of the present invention, wherein (a) shows a state in which the electrodes are arranged to face each other, (b) shows a state in which the electrodes are brought into contact with each other, (c) shows a state of a joining portion to which heating and pressurizing are applied, and (d) shows a state after joining.

Fig. 2 is a conceptual view showing a principle of joining electrodes to each other in another embodiment of the mounting method of the present invention, wherein (a) shows a state in which the electrodes are arranged to face each other, (b) shows a state in which the electrodes are brought into contact with each other, (c) shows a state of a joining portion to which heating and pressurizing are applied, (d) shows a state in which an electronic part is vibrated, and (e) shows of the joining portion after joining.

Fig. 3 is a schematic view showing a state in which an electronic part is mounted on a substrate in a prier art.

Fig.4 is a graph showing shearing strength experiment data of a joining portion in an embodiment 4 and an embodiment 5.

Best Mode for Carrying Out the Invention

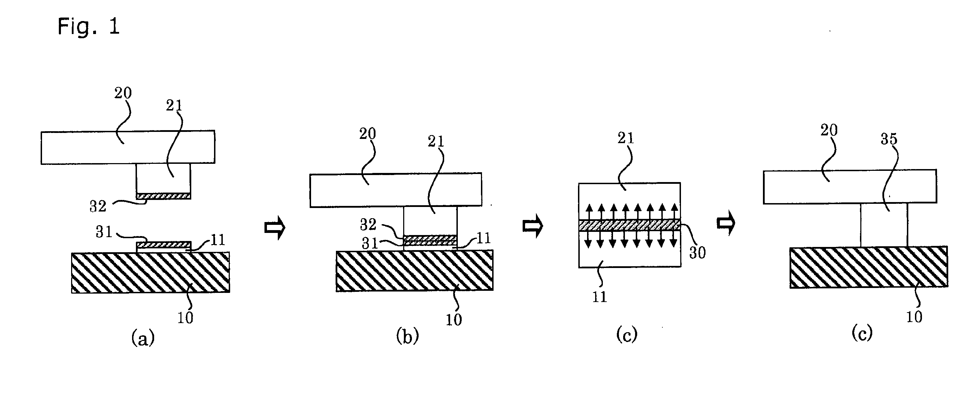

Hereinafter, the present invention is explained in conjunction with the drawings. Fig. 1 shows an embodiment of a mounting method of electronic parts of the present invention.

Fig. 1 is a step view which shows a joining principle of electrodes in the mounting method according to the present invention.

As shown in Fig. 1(a), in this embodiment, a metal-made circuit electrode 11 which is formed on a circuit board 10 and a die electrode 21 made of metal which is formed on an electronic part 20 are arranged to each other, wherein low-melting-point metal layers 31 and 32 are respectively formed on the circuit electrode 11 and the die electrode 21.

As the circuit board 10, for example, a conventionally-known printed wiring board such as a printed circuit board can be used and no specific limitations are imposed on the circuit board 10. Further, the metal-made circuit electrode 11 which is made on the circuit board 10 is not particularly limited to a kind as long as the circuit electrode 11 is made of a metal having conductivity, however, from a point of easiness in performing a solid-liquid diffusion with the low-melting-point metal layers 31 and 32, it is preferable that the metal-made circuit electrode 11 is one kind or an alloy of the kinds of metal selected from Cu, Ni, Au and Al. As a method to form the circuit electrode 11 on the circuit board 10, it is possible to form patterns by a conventionally-known vapor deposition, an etching or the like and the method is not particularly limited to one kind.

As the electronic part 20, for example, a semiconductor chip and the like may be named, however, the electronic part 20 is not limited thereto. Further, as the die electrode 21 which is formed on the electronic part 20, similarly to the above-mentioned circuit electrode 11, no specific limitations are imposed on the die electrode 21, however, from a point of easiness in performing solid-liquid diffusion with the low-melting-point metal layers 31 and 32, it is also preferable that the die electrode 21 is made of one kind or an alloy of the kinds of metal selected from Cu, Ni, Au and Al.

Further, it is preferable that the die electrode 21 is formed as a bump on an electrode pad such as a semiconductor chip. Due to such a constitution, in a flip-chip technique in which a circuit board electrode and the electronic part such as the semiconductor chip are directly connected by the bump, the method of the present invention can be preferably used.

Here, it is preferable that the surface roughness of the circuit electrode 11 and the die electrode 21 is smooth so as to obtain an excellent joining state, however, in the present invention, the surfaces of the circuit electrode 11 and the die electrode 21 may be rough surfaces having a surface roughness Ra of 0.4 to 10 $\mu$m.

Next, the low-melting-point metal layers 31 and 32 are explained. On the circuit electrode 11 and the die electrode 21, the low-melting-point metal layers 31 and 32 having a total thickness equal to 10 $\mu$m or less are respectively formed in advance.

As a metal used for the low-melting-point metal layers 31 and 32, a metal which forms an alloy by solid-liquid diffusion with the circuit electrode 11 and the die electrode 21 may be applied, and further, it is more preferable to apply a metal whose melting point is equal to 220°C or less, or more preferably, a metal whose melting point is equal to 180°C or less. Due to such a condition of the metal, a joint of the low-melting-point metal layers 31 and 32 in a low temperature compared to a conventionally-used tin-lead eutectic solder (whose melting point is at 183°C) or an SnAg type which is a representative lead-free solder (whose melting point is between 210°C to 223°C) becomes possible and hence, a thermal damage to the electronic parts can be controlled.

As such a low-melting-point metal, for example, a metal including at least a kind which is selected from SnIn, In, Bi, and SnBi is named. These metallic materials can be used singularly or in combination and a composition ratio of the metallic materials in case of an alloy can be set accordingly.

Further, on the basis of the above-mentioned metallic materials, a small amount of elements to be added may be included in the alloy. As such elements to be added, for example, Cu, Ni, Ge, Sb, Ag and P or the like may be named.

Here, as mentioned above, as a material for the circuit electrode and the die electrode of the present invention, it is preferable that the material is one kind or an alloy of the kinds of metal selected from Cu, Ni, Au and Al as a material which is easy to perform the solid-liquid diffusion, and Cu is particularly preferable in having a large diffusion coefficient of the low-melting-point metal among these materials.

That is, the degree of diffusion of the solid-liquid diffusion or the like in a joint of the present invention is generally expressed with the diffusion coefficient, wherein as the value of the diffusion coefficient becomes larger, the diffusion is performed more easily. The diffusion coefficient D is experimentally expressed by the formula $D = D_0 exp(-Q/RT)$. Here, the symbols represent, Do: frequency term, Q: activation energy, R: gas constant and T: absolute temperature.

Further, when In is selected as a low-melting-point metal-made material, for example, the diffusion coefficient exhibits $7.18 \times 10^{-6}$ when the material of the electrode is Au, while the value becomes extremely large as expressed by a formula $1.23 \times 10^5$ when the material is Cu.

Further, also in case Sn is selected as a low-melting-point metal-made material, the diffusion coefficient exhibits $3.96 \times 10^{-6}$ when the material of the electrode is Au, while the value becomes large as expressed by a formula $1.05 \times 10^{-5}$ when the material is Cu.

Still further, when the material of the electrode is Ni, there exists no low-melting-point metal-made material having a large diffusion coefficient with respect to this material.

In this manner, when the material of the electrode is Cu, the diffusion coefficient of the low-melting-point metal becomes particularly large and hence, the diffusion reaction in the solid-liquid diffusion is performed fast, therefore Cu is particularly preferable to achieve the solid-liquid diffusion which does not generate a residual low-melting-point metal single layer.

Further, the thickness of the low-melting-point metal layers 31 and 32 is equal to 10 $\mu$m or less in total of both of the layers and it is preferable to set the value between 0.1 to 10 $\mu$m or more preferably, to set the value between 0.1 to 1 $\mu$m.

When the total thickness of the low-melting-point metal layers exceeds 1 $\mu$m, it is not preferable because the diffusion is not completed during a few minutes of joint time, the low-melting-point metal layers tend to remain between the electrodes in a state of a low-melting-point metal therefore lowering reliability of the joint part.

Further, when the total thickness of the low-melting-point metal layers exceeds 1 $\mu$m, in order to avoid the above-mentioned non-reactive layers remaining in the joint part, a pressurization by a large load of approximately several dozen MPa is necessary. Due to the pressurization, the low-melting-point metal which does not contribute to the reaction is discharged from the end of the joint part. Further, the low-melting-point metal which is discharged from the end of the joint part is not uniformly discharged after going around the outer peripheral, due to an influence of the surface tension or the like, the low-melting-point metal tends to remain in clusters in a local part on the outer periphery of the end of the joint part. Further, there is a case in which such a discharged material of the low-melting-point metal may project outwardly in the radial direction in a width of several dozen $\mu$m from the outer peripheral surface of the end of the joint part and there arises a possibility that such a state may be a cause of a short-circuiting defect in a high density packaging.

Further, assuming the total thickness of the low-melting-point metal layer is equal to 0.1 $\mu$m or less, it is not preferable because the joint is not performed sufficiently due to the influence of the surface roughness of the electrode which is the base metal. That is, a lower limit of film thickness of the low-melting-point metal layer is dependent on the surface roughness of the electrode, wherein assuming the low-melting-point metal layer is sufficiently thick with respect to the surface roughness of the electrode, film surfaces of the soft low-melting-point metal layers adhere to each other without a gap by pressurization and hence, it is possible to form a dispersion film without a void. However, it is considered that the surface roughness of the electrode surface of an electronic part is generally equal to 0.1 $\mu$m or less and hence, the lower limit of the total thickness of the low-melting-point metal layers exhibits 0.1 $\mu$m.

As a method of forming the low-melting-point metal layers 31 and 32, the above-mentioned conventionally-known thin film forming method is available, while the thin film forming method is not particularly limited to the method and a vapor-deposition, a sputtering, a plating, an etching or the like can be used accordingly. Further, by the vapor-deposition using a metal mask, the etching using a photo resist and the like, the low-melting-point metal layers are formed by a pattern-forming as required to mount thereon. Here, as mentioned above, the supply amount of the low-melting-point metal to be a joint material can be extremely small and hence, the thickness of the low-melting-point metal layer 30 can be extremely thin and the fine patterning becomes possible.

Here, in the present invention, the respective thicknesses of the low-melting-point metal layers 31 and 32 may be made different from each other. Further, it may be possible that only either one of the low-melting-point metal layers 31 and 32 is formed.

With respect to the above-mentioned method for forming the low-melting-point metal layers 31, 32, it is preferable to use a method in which at least two kinks of metal which can form a two-or-more-element alloy such as the above-mentioned SnIn or SnBi are stacked in two or more layers and these stacked metal layers are preheated to make the metal layers react with each other thus forming the alloy layer.

For example, in case of SnIn, it is known that although the melting point of Sn is 232°C and the melting point of In is 157°C, 26.4% of Sn is melted in In by solid solution at a temperature of 121°C which is lower than 157°C.

Accordingly, the Sn layer and the In layer are stacked preliminarily and the stacked layers are made to react with each other by preheating thus forming the SnIn alloy layer having the low-melting-point metal layers 31, 32 and, thereafter, the alloy layer is diffused into the circuit electrode 11 and the die electrode 21 by solid-liquid diffusion thus joining the circuit electrode 11 and the die electrode 21.

Due to such a method, there are no irregularities with respect to the alloy composition and alloy supply quantity in the alloy layer and hence, it is possible to surely perform the joining at a low temperature thus acquiring a highly reliable joining portion. Here, in case of the above-mentioned SnIn alloy, it is preferable to stack the layers such that the In layer forms the uppermost surface. Due to such a constitution, it is possible to prevent the Sn layer from being oxidized.

Although the film thicknesses of the respective single metal layers are suitably selected in conformity with the target alloy composition, it is preferable that the respective single metal layers have small thicknesses from a view point of the formation of an alloy layer. To be more specific, it is preferable that the film thicknesses of the single metal layers are set to values which fall within a range from 0.1 to 1 $\mu$m. Further, the respective single metal layers may be formed such that each single metal layer is formed of one layer or may be formed of a plurality of layers which are stacked alternately.

As another method for forming the low-melting-point metal layers 31, 32, when the low-melting-point metal is a two-or-more-element alloy such as SnIn or SnBi, it is preferable to use a method in which the low-melting-point metal layers 31, 32 are formed by vapor deposition using the alloy as an evaporation source, and a film having the target alloy composition is formed by controlling the vapor pressure ratio of the respective metal components of the alloy at the time of performing the vapor deposition.

As described above, the temperature at the time of joining depends on the melting points of the low-melting-point metal layers 31, 32. For example, with respect to the SnIn alloy, for example, the eutectic temperature is 117°C and the eutectic composition at such a temperature is In:Sn=52:48. Accordingly, outside this eutectic composition, the melting points of the low-melting-point metal layers 31, 32 are elevated and hence, to ensure the stable low-temperature joining, it is necessary to maintain the alloy composition of the low-melting-point metal layers 31, 32 at In:Sn=52:48.

However, usually, when the alloy thin film layer is formed by the vapor deposition method which uses the base alloy as the single evaporation source, the vapor pressures differ from each other depending on the respective metal components and hence, even when the base alloy whose composition is preliminarily set to In:Sn=52:48 is used as the evaporation source, since the vapor pressures of In and Sn are not equal, the composition of the formed vapor deposition film is displaced from the target composition. Accordingly, by controlling the vapor pressure ratio of respective metal components of the alloy, it is possible to form the film while maintaining the target alloy composition.

Particularly, by preliminarily obtaining the vapor pressure ratio of the respective components which makes the alloy composition of the evaporation source and the alloy composition of the alloy layer after vapor deposition equal to each other and by controlling the vapor pressure ratio during the vapor deposition, it is possible to obtain a vapor deposition film having the same composition as the base alloy of the evaporation source as the low-melting-point metal layers and hence, it is possible to eliminate the displacement of the composition of the formed vapor deposition film from the target composition. The vapor pressure ratio of the respective metal components which constitutes the control condition can be obtained by the following calculation, for example.

First of all, a main component of an alloy steam is an atom of metal including an alloy and hence, the partial pressure can be estimated by expansively applying the law of Raoult with respect to steam pressure of a solvent of a diluted solution as a formula (1) shown below.

$$a_i = \chi_i \qquad\qquad\qquad (1)$$

Here, $a_i$ and $\chi_i$ indicate an activity and a mol fraction of an i-th component, respectively. Assuming that a steam pressure in a state of alloy of the i-th component as $P_i$ and a steam pressure in a pure state of the i-th component is $P_{i(0)}$, a formula $a_i = P_i/P_{i(0)}$ is established by means of the definition.

Since it is a rare case that the formula (1) is established as it is, for indicating a degree of shifting of a measured value of $a_i$ from the law of Raoult, an activity coefficient $\gamma_1$ which is defined by a formula (2) shown below is used.

$$a_i = \gamma_i\chi_i \qquad\qquad\qquad (2)$$

Since a partial molal free energy change $\Delta G_i$ is given by a formula (3) shown below, the formula can be modified to a formula (4) by using a formula (2).

$$\Delta G_i = RT \ln a_i \tag{3}$$

$$\Delta G_i = RT \ln \gamma_i + RT \ln \chi_i \tag{4}$$

Here, R and T are assumed as gas constant and absolute temperature, respectively. Further, a free energy $\Delta G_i$ in a composition X is indicated by a formula (5) shown below.

$$\Delta G_i = X(1-X)(A_{ij} + (1-2X)B_{ij} + C_{ij}X(1-X)) \tag{5}$$

Here, for example, in the case of the eutectic temperature of SnIn, as shown above, a composition X=52 of In, and a composition X=48 of Sn.

Here, in consideration of a reactivity of In and Sn, by substituting $A_{ij}$=-12990, $B_{ij}$=-14383, $C_{ij}$=23982 and X=0.52 for the respective coefficient of the formula (5), a formula shown below is obtained.

$$\Delta G_i = -1604.62 \text{J/mol} \tag{6}$$

In a same manner, in consideration of a reactivity of Sn and Cu, by substituting $A_{ij}$=-35479, $B_{ij}$=-19182, $C_{ij}$=59493 and X=0.48 for the respective coefficient of the formula (5), a formula shown below is obtained.

$$\Delta G_i = -5340.65 \text{J/mol} \tag{7}$$

By using the formula (3) and (6), an activity $a_A$ is obtained, and by using the formula (3) and (7), an activity $a_B$ id obtained. Hereby, formulae (8) and (9) shown below are established. Here, R=8.314[$J \cdot mol^{-1} \cdot K^{-1}$], T=700K(427°C).

$$a_A = \exp(\Delta G_i / RT) = 0.835 \tag{8}$$

$$a_A = \exp(\Delta G_i / RT) = 0.632 \tag{9}$$

Then, in consideration of a flux of respective components in vacuum vapor deposition, assuming a surface composition $\chi_A$, $\chi_B$ at a certain instant when a binary alloy is evaporating, a vapor flux ratio $J_A/J_B$ is indicated by formulae (10), (11) shown below.

$$J_A/J_B = (a_A P_A / a_B P_B)(M_B/M_A)^{1/2} = (\gamma_A \chi_A P_A / \gamma_B \chi_B P_B)(M_B/M_A)^{1/2} = Z(\chi_A/\chi_B) \tag{10}$$

$$Z = (\gamma_A P_A / \gamma_B P_B)(M_B/M_A)^{1/2} \tag{11}$$

When a value Z of the formulae (10), (11) becomes 1, the condition that the evaporating component ratio equals a composition of the original alloy (composition $\chi_A$=52 of In, composition $\chi_B$=48 of Sn) is established. Here, therefore, by substituting molecular mass $M_A$=114.818 of In, molecular mass $M_B$=118.710, $a_A$=0.835, $a_B$=0.632 and Z=1 for the formula (10), the following value is obtained.

$$(P_A/P_B) = Z(\chi_A/\chi_B)(a_B/a_A)(M_A/M_B)^{1/2} = 0.81 \tag{12}$$

Accordingly, by performing the vapor deposition under conditions in which the vapor pressure satisfy the formula (12), it is possible to form a SnIn eutectic alloy film on the Cu film such that the ratio between In and Sn becomes In: Sn=52:48.

Here, the above-mentioned vapor pressure ratio $(P_A/P_B)$ can be controlled by controlling the temperature of an evaporation source or the degree of vacuum during vapor deposition at the time of actually performing the vapor deposition. Among these factors, a temperature of the base alloy which constitutes the evaporation source can be controlled by adjusting the energy of electron beams for heating when an electron beam vapor deposition apparatus is used. When the temperature of the base alloy in a molten state is changed due to the adjustment of the electron beam energy, evaporation speeds and activities from the evaporation sources of respective metal components are respectively changed, wherein relative change rates of the evaporation speeds and the activities corresponding to the temperature change differ from each other for respective metal components and hence, the vapor pressure ratio is changed.

Next, the degree of vacuum during the vapor deposition is adjusted by evacuating the inside of a vapor deposition vessel using a vacuum pump. When the sum of vapor pressures of the respective metal components is changed due to the adjustment of the degree of vacuum, molar fractions of respective metal components are changed, and the activities of the respective metal components are changed. However, by making the relative change rates of the activities with respect to the change of vacuum different from each other for respective metal components, the vapor pressure ratio is changed.

Either one of the temperature of the evaporation source and the degree of vacuum during vapor deposition may be controlled or the controls of both parameters may be combined.

Further, the values of the coefficients $A_{ij}$, $B_{ij}$, $C_{ij}$ which are substituted for the formula (5) in obtaining the activities $a_A$, $a_B$ in the In-Cu reaction and Sn-Cu reaction are physical values which are obtained based on predetermined reference temperature conditions and hence, the heater heating temperature with respect to the vapor deposition object is adjusted such that the temperature of the Cu electrode which constitutes the vapor deposition object becomes the above-mentioned reference temperature.

Here, in the present invention, in place of the vapor pressure ratio in the reaction steps of the respective metal components during the above-mentioned vapor deposition, a product of the vapor deposition ratio and the activity coefficient ratio in the reaction steps of the respective metal components may be controlled.

In this case, for example, assuming the respective compositions of In and Sn in the SnIn eutectic alloy as $W_A$, $W_B$ (weight%) following formula (13), (14) are established.

$$\chi_A = 1/(1+(W_B/W_A)(M_A/M_B) \tag{13}$$

$$\chi_B = 1/(1+(W_A/W_B)(M_B/M_A) \tag{14}$$

Accordingly, by substituting the above-mentioned formulas (13), (14) for the formulas (10), (11), the vapor flux weight ratio $\Gamma_A/\Gamma_B$ is expressed by the following formula (15).

$$\Gamma_A/\Gamma_B = (\gamma_A\chi_A p_A/\gamma_B\chi_B p_B)(M_A/M_B)^{1/2} = (\gamma_A p_A/\gamma_B p_B)(M_B/M_A)^{1/2}(W_A/W_B) \tag{15}$$

By substituting a molecular weight $M_A$=114.818 of In, a molecular weight of $M_B$=118.710 of Sn, a weight% $W_A$=0.52 of In and a weight% $W_B$=0.48 of Sn for the formula as (13), (14), $\chi_A$=0.528, $\chi_B$=0.472 are obtained.

Accordingly, to calculate the ratio $(\gamma_A p_A/\gamma_B p_B)$ which makes the left side $(\Gamma_A/\Gamma_B)$ in the formula (15) to assume 0.52/0.48, following value is obtained.

$$(\gamma_A p_A/\gamma_B p_B) = (\Gamma_A/\Gamma_B)(M_B/M_A)^{1/2}(\chi_B/\chi_A) = 0.98 \tag{16}$$

Accordingly, by performing the vapor deposition under conditions in which the activity coefficient and the vapor pressure satisfy the formula (16), it is possible to form a SnIn eutectic alloy film on the Cu film such that the ratio between In and Sn becomes In:Sn=52:48.

Here, the above-mentioned product of the vapor pressure ratio and the activity coefficient ratio ($\gamma_A p_A/\gamma_B p_B$) is controllable by controlling the temperature of the evaporation source, the degree of vacuum during vapor deposition and the temperature of object to be vapor-deposited at the time of actually performing the vapor deposition.

Among these factors, the temperature of the base alloy which constitutes the evaporation source can be controlled by adjusting the energy of electron beams for heating when an electron beam vapor deposition apparatus is used. When the temperature of the base alloy in a molten state is changed due to the adjustment of the electron beam energy, evaporation speeds and activities from the evaporation sources of respective metal components are respectively changed, wherein relative change rates of the evaporation speeds and the activities corresponding to the temperature change differ from each other for respective metal components and hence, the vapor pressure ratio is changed.

Next, the degree of vacuum during the vapor deposition is adjusted by evacuating the inside of a vapor deposition vessel using a vacuum pump. When the sum of vapor pressures of the respective metal components is changed due to the adjustment of the degree of vacuum, molar fractions of respective metal components are changed, and the activities of the respective metal components are changed. However, by making the relative change rates of the activities with respect to the change of vacuum different from each other for respective metal components, the vapor pressure ratio is changed.

Next, the temperature of the Cu electrode which constitutes the object to be evaporated can be adjusted by the electricity supplied to the heating heater. When the temperature of the Cu electrode which constitutes the object to be evaporated is changed due to the adjustment of the electricity supplied to the heater, the activities in the reactions between the respective metal components In, Sn and the base material Cu are changed. However, since the relative change ratios of the activities corresponding to the temperature change differ for respective metal components, the activity coefficient ratio is change.

Among respective control factors consisting of the temperature of the evaporation source, the degree of vacuum during vapor deposition and the temperature of the object to be vapor-deposited, any one of these control factors may be controlled or a plurality of control factors may be controlled in combination.

Here, in obtaining control parameter values corresponding to the target film composition ratio using the vapor deposition process provided with conditions, to obtain provisional control parameter values which are set in the first process, a method which controls the vapor pressure ratio of respective metal components is more appropriate, while to obtain corrected values of control parameters which are set in the second or subsequent process which is performed thereafter, a method which controls the product of the vapor pressure ratio of the respective metal components and the activity coefficient ratio is more appropriate and hence, at a stage of providing conditions, it is more efficient to combine both methods.

Further, the method which can obtain the vapor deposition film having the same composition as the base alloy of the evaporation source as the low-melting-point metal layer has been explained heretofore, the method for forming the low-melting-point metal layer according to the present invention is not limited to the above-mentioned method and may obtain the vapor deposition film having the composition different from the composition of the base alloy of the evaporation source. In this case, corresponding to the relationship between the composition ratio of the base alloy of the evaporation source and the target film composition ratio, a control target object of the vapor pressure ratio of the respective metal components or a control target value of the product of the vapor pressure ratio of the respective metal components and the activity coefficient ratio is determined.

Next, in a state that the low-melting-point metal layers 31, 32 are arranged to face each other as shown in Fig. 1(a), the electronic part 20 is moved to the circuit substrate 10 side and is arranged such that the low-melting-point metal layers 31, 32 are brought into contact with each other as shown in Fig. 1(b).

Then, when the heating and the pressuring are performed in such a state at a temperature of 200°C or less, as shown in Fig. 1(c), the low-melting-point metal layers 31, 32 are melted thus forming the low-melting-point metal layer 30. Further, the low-melting-point metal is diffused into the circuit electrode 11 and the die electrode 21 by solid-liquid diffusion thus performing the joining as shown in Fig. 1 (d).

Here, the positioning of the above-mentioned electrodes and the manipulation such as moving, heating, pressurizing and the like are performed by a conventionally known mounting equipment. For example, it is possible to perform such positioning and manipulation using a flip chip bonder or the like. Further, the positioning of electrodes can be accurately performed by determining coordinates using a camera or the like.

In this manner, according to the present invention, it is possible to perform the heating and pressurizing at a temperature of 200 °C or less. Accordingly, the present invention can perform the joining at a lower temperature compared to 200 to 250 °C which is the general heating temperature in the conventional solder joining and hence, thermal damages applied to the electronic part 20 can be suppressed. In this case, it is more desirable to set the heating temperature at the time of joining to a temperature higher than melting points of the low-melting-point metal layers 31, 32 by 0 to 100 °C.

Further, in this embodiment, the heating and pressurizing state is maintained until the low-melting-metal of the low-melting-point metal layer 30 is completely diffused in the circuit electrode 11 and the die electrode 21 by the solid-liquid diffusion. In the present invention, it is preferable to perform the heating and pressurizing for a predetermined time until the low-melting-point metal is completely diffused into the electrodes by the sold-liquid diffusion.

Accordingly, as shown in Fig. 1(d), in the joining portion after joining, a joined electrode 35 is formed as a single alloy layer as a whole. Although the joined electrode 35 has a concentration gradient of the low-melting-metal which advances toward respective electrode sides from a center portion thereof, the joined electrode 35 forms the single alloy layer as a whole.

Accordingly, no intermediate alloy layer is separately formed in the joined electrode 35 and hence, the reliability of the joined portion does not depend on the characteristic of the interposed joining material but mainly depends on the base metals of the electrodes. Accordingly, compared to soldering or the like, it is possible to enhance the reliability of the connected portion.

In this manner, the time which is necessary for the low-melting-point metal layer to be completely diffused in the electrode by solid-liquid diffusion is, although the time differs depending on the heating temperature, the pressure, the electrode material, the material of the low-melting-point metal or the like, usually, 10 to 180 seconds.

Further, the pressurizing condition is, although the pressurizing condition differs depending on the above-mentioned heating temperature, the electrode material, the material of the low-melting-point metal or the like, preferably 10 to 30 MPa.

Further, as described above, when the surfaces of the circuit electrode 11 and the die electrode 21 are coarse surfaces having a surface roughness Ra of 0.4 to 10 $\mu$m, it is preferable that the circuit electrode 11 and the die electrode 21 are pressurized so that the circuit electrode 11 and the die electrode 21 can be joined to each other at the time of joining in a state where both of the rough surfaces are plastically deformed. Due to such a constitution, the pressurizing is performed until the surfaces of the electrode are plastically deformed and hence even when there exist irregularities on the surfaces of the formed electrodes due to a precipitation condition, irregularities or the like of electrolytic plating, it is possible to acquire the favorable joining state. In this case, the pressurizing condition is preferably 30 to 100 MPa.

As described above, when each low-melting-point metal layer 31, 32 is formed of an alloy layer which is obtained by reacting two or more single metal layers, it is desirable that, first of all, preheating is performed at a temperature equal to or lower than the melting points of respective single metals thus forming a metal layer of two or more single metal layers in solid solution and, thereafter, heating and pressurizing are performed at a temperature equal to or less than 200°C.

In this case, although the temperature of the preheating may be suitably selected based on kinds and film thicknesses of the single metal layers which form the alloy layer, for example, when the alloy layer adopts the two-layer constitution formed of the Sn layer and the Inlayer, it is preferable to perform the preheating at a temperature of 110 to 125°C.

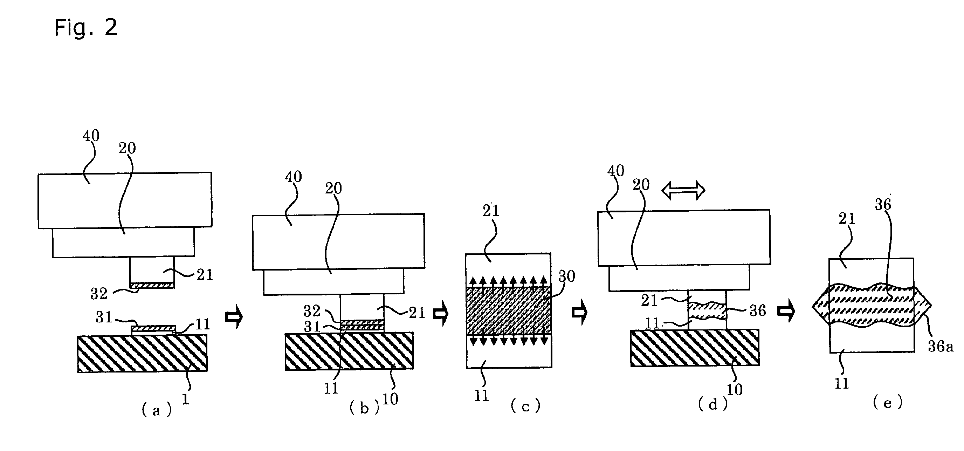

Fig. 2 shows another embodiment of the mounting method of the present invention. Here, in the explanation of the embodiment made hereinafter, parts identical with the parts of the above-mentioned embodiment are given same symbols and their explanation is omitted.

In this embodiment, as shown in Fig. 2(a), low-melting-point metal layers 31, 32 which are formed on a circuit electrode 11 and a die electrode 21 are arranged to face each other to perform positioning, and as shown in Fig. 2(b), the low-melting-point metal layers 31, 32 are brought into contact with each other. Then, in such a state, the circuit electrode 11 and the die electrode 21 are heated and pressurized as shown in Fig. 2(c) thus melting the low-melting-point metal layers 31, 32 to form a low-melting-point metal layer 30. Further, as shown in Fig. 2(d), the heating and the pressurizing are performed until an intermediate alloy layer 36 is formed due to the diffusion reaction of the circuit electrode 11 and the die electrode 21.

Then, after the formation of the intermediate alloy layer 36, in addition to the pressurizing, as shown in Fig. 2 (d), the electronic part 20 is vibrated laterally along the direction indicated by an arrow in Fig. 2(d) by a head portion 40 of a flip chip bonder which holds the electronic part 20.

By vibrating the electronic part 20 laterally in the pressurized state, oxide in the low-melting-point metal is removed so that a contact state of non-contact portions of both electrodes which face each other in an opposed manner is enhanced. Further, an excessive amount of low-melting-point metal which is extruded by pressurizing and vibration projects from outer peripheries of side surfaces of the joining portion as projecting portions 36a and hence, only the intermediate alloy layer 36 is interposed between the circuit electrode 11 and the die electrode 21 as a joining portion of the circuit electrode 11 and the die electrode 21 thus obtaining the joining portion where the excessive low-melting-point metal does not remain.

In the above-mentioned heating and pressurizing step, the time necessary for forming the intermediate alloy layer 36 is suitably set based on the heating temperature, the pressure, the electrode material, the material of the low-melting-metal or the like, compared to the embodiment which completely diffuses the low-melting-point metal, such time is short and may be usually 1 to 5 seconds.

Here, it is preferable that the thickness of the intermediate alloy layer 36 in the joining portion is set to a value which falls within a range from 1 to 5 µm. Further, the explicit presence of the intermediate alloy layer 36 can be also confirmed by the observation of a cross section and, at the same time, the presence of the intermediate alloy layer 36 can be also confirmed in a nondestructive manner by measuring the electric resistance, the heat resistance or the like.

According to this embodiment, it is sufficient to heat the low-melting-point metal layers up to a stage in which the low-melting-point metal layers are not completely diffused and it is sufficient to form the intermediate alloy layer and hence, the time necessary for joining can be largely shortened. Further, a supply quantity of the low-melting-point metal is enough so long as a quantity of low-melting-metal which is necessary for forming the intermediate alloy layer is supplied and hence, a strict management of the supply quantity of the low-melting-metal becomes no more necessary.

As described above, according to the present invention, it is possible to provide a mounting method of an electronic part which can, compared to the conventional joining method which uses solder or an adhesive agent, perform the joining at a low temperature and within a short time thus suppressing damages applied to an electronic part attributed to heating at the time of performing the joining and, at the same time, can enhance the productivity. Further, such mounting method of an electronic part can enhance the reliability of the joining portion and, at the same time, can realize the joining at a fine pitch.

Hereinafter, the mounting method of an electronic part of the present invention is explained in further detail in conjunction with examples.

Example 1

An electronic part was mounted on a circuit board using the method shown in Fig. 1.

First of all, a semiconductor chip was used as the electronic part, and bumps made of Cu were formed on the semiconductor chip as electrodes. On the other hand, Cu electrodes were formed on the circuit board.

Next, as a low-melting-point metal layer, on the Cu bump of the semiconductor chip and on the Cu electrode of the circuit board, an SnIn layer (melting point: 117°C) having a total thickness of 4 µm, wherein an Sn layer had a thickness of 2 µm and In layer had a thickness of 2 µm was formed by vapor deposition.

Here, in a vapor deposition method, mother alloy made of SnIn (In:Sn=52:48) was used as an evaporation source, and a film was formed by controlling the vapor deposition condition such that the vapor pressure ratio ($p_A/p_B$) =0.81 in the above-mentioned formula (12) became ($p_A/p_B$)=0.81. Here, an electron beam vapor deposition apparatus was used as a vapor deposition apparatus, wherein the degree of vacuum at the time of vapor deposition was set to $10^{-5}$ Pa and the vapor deposition speed was set to 0.4 nm/min.

As a result, when the composition of the formed SnIn thin film was examined by analyzing a cross-sectional sample using a micron-AES analysis, the composition of the SnIn thin film was set to In:Sn=52:48 and hence, the low-melting-point metal layer having the target alloy composition was obtained.

Then, as shown in Fig. 1(a), the Cu bump of the semiconductor chip and the Cu electrode of the circuit board were aligned with each other and, thereafter, the electrodes were brought into contact with each other as shown in Fig. 1(b). Then, as shown in Fig. 1(c), the Cu bump and the Cu electrode were heated and pressurized at a temperature of 137°C which was higher than the melting point of the SnIn by 20°C and at a pressure of 90 MPa for 30 seconds thus joining the Cu bump and the Cu electrode.

As a result, as shown in Fig. 1(d), it was confirmed by a cross-section observation using a high vacuum scanning electron microscope and an element analysis of a joining interface by an X-ray micro analyzer (EPMA) that SnIn was completely diffused in the Cu electrode and the joining portion which constitutes one alloy layer as a whole in which an intermediate alloy layer was not present was obtained.

Embodiment 2

The joining of a semiconductor chip and a circuit board was performed under the same condition as in the embodiment 1 except for that, in the formation of the low-melting-point metal layer vapor deposition, a film was formed by controlling the temperature of the evaporation source, the degree of vacuum during vapor deposition and the temperature of the object to be vapor deposited at the time of actually performing the vapor deposition so that the product of the vapor pressure ratio and the activity coefficient ratio in the above-mentioned formula (16) becomes ($\gamma_A p_A/\gamma_B p_B$) =0.98.

As a result, the composition of the formed SnIn thin film was set to In:Sn=52:48 and hence, the low-melting-point metal layer having the target alloy composition was obtained. Further, after joining, as shown in Fig. 1(d), it was confirmed by a cross-section observation using a high vacuum scanning electron microscope and an element analysis of a joining interface by an X-ray micro analyzer (EPMA) that SnIn was completely diffused in the Cu electrode and the joining portion which constituted one alloy layer as a whole in which an intermediate alloy layer was not present was obtained.

Example 3

An electronic part was mounted on a circuit board using the method shown in Fig. 1.

First of all, a semiconductor chip was used as the electronic part, and bumps made of Cu were formed on the semiconductor chip as electrodes. On the other hand, Cu electrodes were formed on the circuit board.

Next, as a low-melting-point metal layer, on the Cu bump of the semiconductor chip and on the Cu electrode of the circuit board, an Sn layer having a thickness of 0.48 $\mu$m and an In layer having a thickness of 0.52 $\mu$m were sequentially formed as a single metal layer by vapor deposition such that a total thickness became 1 $\mu$m.

Then, as shown in Fig. 1(a), the Cu bump of the semiconductor chip and the Cu electrode of the circuit board were aligned with each other and, thereafter, as shown in Fig. 1(b), the electrodes were brought into contact with each other. Then, preheating was performed at a temperature of 120°C for 10 seconds so as to form the Sn layer and the In layer into solid-solution thus acquiring a SnIn alloy layer.

Thereafter, as shown in Fig. 1(c), heating and pressuring were performed at a temperature of 137°C which was higher than the melting point of SnIn by 20°C and at a pressure of 90 MPa for 30 seconds thus joining the circuit electrode 11 and the die electrode 21.

As a result, as shown in Fig. 1(d), it was confirmed by a cross-section observation using a high vacuum scanning electron microscope and an element analysis of a joining interface by an X-ray micro analyzer (EPMA) that SnIn was completely diffused in the Cu electrode and the joining portion which constituted one alloy layer as a whole in which an intermediate alloy layer was not present was obtained.

Embodiment 4

An electronic part was mounted on a circuit board using the method shown in Fig. 1.

First of all, a semiconductor chip was used as the electronic part, and bumps made of Cu were formed on the semiconductor chip as electrodes. On the other hand, Cu electrodes were formed on the circuit board.

Next, as a low-melting-point metal layer, on the Cu bump of the semiconductor chip and on the Cu electrode of the circuit board, In layers respectively having a thickness of 0.5 $\mu$m and 0.5 $\mu$m and a total thickness of 1 $\mu$m (a melting point: 157°) were formed by vapor deposition.

Then, as shown in Fig. 1(a), the Cu bump of the semiconductor chip and the Cu electrode of the circuit board were aligned with each other and, thereafter, as shown in Fig. 1(b), the electrodes were brought into contact with each other. Thereafter, as shown in Fig. 1(c), heating and pressuring were performed at a temperature of 177°C which was higher than the melting point of In by 20°C and at a pressure of 30 MPa for 60 seconds thus joining the circuit electrode 11 and the die electrode 21.

As a result, as shown in Fig. 1(d), it was confirmed by a cross-section observation using a high vacuum scanning electron microscope and an element analysis of a joining interface by an X-ray micro analyzer (EPMA) that In was completely diffused in the Cu electrode and the joining portion which constitutes one alloy layer as a whole in which an intermediate alloy layer is not present was obtained.

Further, with respect to the joining portion, when a state of discharge of In from an end of the joining portion was observed, no discharge of In from the end of the joining portion was found.

Embodiment 5

A joining portion of the embodiment 5 was obtained by joining the circuit electrode 11 and the die electrode 21 in the same manner as in the embodiment 4 except for that In layers respectively having a thickness of 1 $\mu$m and 1 $\mu$m and a total thickness of 2 $\mu$m were formed by vapor deposition as low melting point metal layers. With respect to the joining portion, when a state of discharge of In from an end of the joining portion was observed, the discharge of In of approximately 10 to 20 $\mu$m from the end of the joining portion was found.

Next, joining portion samples for a shearing strength test were prepared using the same materials and same joining conditions as in the embodiment 4 and the embodiment 5 and a shearing force was applied in the direction parallel to a joining surface. When the shearing strength test was carried out, a result shown in Fig. 4 was obtained.

Fig. 4 shows the relationship between the thickness ($\mu$m) of an In film which constitutes a low melting point metal layer and the shearing stress (MPa). That is, Fig. 4 shows the shearing stress test data with respect to 5 pieces of the joining portion samples when the thickness ($\mu$m) of the In film is 0.5 $\mu$m (total thickness: 1 $\mu$m) in the embodiment 4 and with respect to 4 pieces of the joining portions samples when the thickness ($\mu$m) of the In film is 1 $\mu$m (total thickness: 2 $\mu$m) in the embodiment 5.

It is understood from the result in Fig. 4 that the joining portion of the embodiment 4 and the joining portion of the embodiment 5 are substantially equal with respect to the shearing stress characteristic.

As described above, it is understood that the joining portion of the embodiment 4 in which the total thickness of the low melting point metal layers made of In is set to 1 $\mu$m has the substantially equal shearing stress characteristic as the joining portion of the embodiment 5 in which the total thickness of the low-melting-point metal layers made of In is set to 2 $\mu$m and, at the same time, there is no discharge of the low melting point metal layer at the end of the joining portion. The joining portion of the embodiment 4 particularly constitutes a joining portion which is particularly favorably applicable to the narrow pitch mounting.

Industrial Applicability

The present invention is preferably applicable to the direct mounting of an electronic part such as a semiconductor chip on a circuit board such as a printed circuit board in a circuit board or a module (a multiple module) or the like which is required to be miniaturized, for example.

**Claims**

1.    An electronic part mounting method which joins circuit electrodes which are made of metal and are formed on a circuit board and die electrodes which are made of metal and are formed on the electronic parts thus mounting the electronic parts on the circuit board,
wherein a low-melting-point metal layer is preliminarily formed on the circuit electrode and/or the die electrode and, thereafter, the circuit electrode and the die electrode are arranged to face each other, the circuit electrode and/or the die electrode are heated at a temperature which melts at least the low-melting-point metal thus diffusing the low-melting-point metal layer into the circuit electrode and the die electrode by solid-liquid diffusion whereby the circuit electrode and the die electrode are joined to each other.

2.    An electronic part mounting method according to claim 1, wherein the low-melting-point metal layer contains at least one selected from a group consisting of SnIn, In, Bi, SnBi.

3.    An electronic part mounting method according to claim 2, wherein the heating temperature at the time of the joining is 0 to 100°C higher than the melting point of the low-melting-point metal.

4.    An electronic part mounting method according to any one of claims 1 to 3, wherein the total thickness of the low-melting-point metal layer which is formed preliminarily between the circuit electrode and the die electrode to be joined assumes a value which falls within a range from 0.1 to 1 $\mu$m.

5.    An electronic part mounting method according to any one of claims 1 to 4, wherein material of the circuit electrodes and the die electrodes is one selected from a group consisting of Cu, Ni, Au, Al or alloy thereof.

6.    An electronic part mounting method according to any one of claims 1 to 5, wherein the surfaces of the circuit electrode and the die electrode are coarse surfaces having a surface roughness Ra of 0.4 to 10 $\mu$m, and the coarse surfaces are plastically deformed at the time of joining to enable the joining of the circuit electrode and the die electrode.

7.    An electronic part mounting method according to any one of claims 1 to 6, wherein the heating and the pressurizing are performed until the low-melting-point metal layer is completely diffused in the circuit electrode and the die electrode by solid-liquid diffusion.

8.    An electronic part mounting method according to any one of claims 1 to 6, wherein the heating and the pressurizing are performed until an intermediate alloy layer is formed between the circuit electrode and the die electrode.

9.    An electronic part mounting method according to any one of claims 1 to 8, wherein the low-melting-point metal layer is formed such that at least two kinds of metal which can form an alloy are stacked in two or more layers, and the stacked metal layers are preheated to make the metal layers react with each other to form an alloy layer.

10.   An electronic part mounting method according to any one of claims 1 to 8, wherein the low-melting-point metal layer is formed by vapor-depositing an alloy which constitutes an evaporation source and, at the time of performing the vapor deposition, an evaporation pressure ratio in reaction steps of respective components of the above-mentioned alloy is controlled thus forming a film having the target alloy composition.

11.   An electronic part mounting method according to any one of claims 1 to 8, wherein the low-melting-point metal layer is formed by vapor-depositing an alloy which constitutes an evaporation source and, at the time of performing the vapor deposition, the product of an evaporation pressure ratio and an active coefficient ratio in reaction steps of respective components of the alloy is controlled thus forming a film having the target alloy composition.

Fig. 1

(a)    (b)    (c)    (c)

Fig. 2

( a )    ( b )    ( c )    ( d )    ( e )

EP 1 734 570 A1

## Fig. 3

(a)

(b)

## Fig. 4

Total Thickness of In Film (μm)

EP 1 734 570 A1

## INTERNATIONAL SEARCH REPORT

| | International application No. |
|---|---|
| | PCT/JP2004/002534 |

### A. CLASSIFICATION OF SUBJECT MATTER
Int.Cl⁷ H01L21/60

According to International Patent Classification (IPC) or to both national classification and IPC

### B. FIELDS SEARCHED

Minimum documentation searched (classification system followed by classification symbols)
Int.Cl⁷ H01L21/60, H01L21/50

Documentation searched other than minimum documentation to the extent that such documents are included in the fields searched
| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| E,X | JP 2004-111936 A (Fuji Electric Holdings Co., Ltd.), 08 April, 2004 (08.04.04), Full text; all drawings (Family: none) | 1-11 |
| Y | JP 2002-289768 A (Rohm Co., Ltd.), 04 October, 2002 (04.10.02), Full text; all drawings & US 2002/0149117 A1 full text; all drawings & EP 1229583 A1 & WO 02/07219 A1 & KR 2030116 A & TW 518740 B | 1-11 |

☒ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 June, 2004 (16.06.04) | 06 July, 2004 (06.07.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

19

**INTERNATIONAL SEARCH REPORT**

International application No.

PCT/JP2004/002534

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 2001-274201 A (Toshiba Corp.),<br>05 October, 2001 (05.10.01),<br>Full text; all drawings<br>(Family: none) | 1-11 |
| Y | JP 8-003732 A (Seiko Instruments Inc.),<br>09 January, 1996 (09.01.96),<br>Full text; all drawings<br>(Family: none) | 10-11 |
| E,X | JP 2004-111935 A (Fuji Electric Holdings Co.,<br>Ltd.),<br>08 April, 2004 (08.04.04),<br>Full text; all drawings<br>(Family: none) | 1-11 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002043348 A
- JP 5009713 A